# EUROPEAN PATENT APPLICATION

(11) **EP 4 607 575 A1**
(43) Date of publication of application: **27.08.2025**
(21) Application number: 23882125.0
(22) Date of filing: 15.02.2023
(51) Int. Cl.: H01L 21/60, H01L 21/50, H01L 21/67, H05K 13/04

(54) **SUBSTRATE PROCESSING DEVICE AND SUBSTRATE PROCESSING METHOD**

(30) Priority: 27.10.2022 JP 2022172036
(71) Applicant: Tokyo Electron Limited, Tokyo 107-6325 (JP)
(72) Inventor: MATSUOKA, Nobuaki, Koshi City, Kumamoto 861-1116 (JP)
(74) Representative: Manitz Finsterwald Patent- und Rechtsanwaltspartnerschaft mbB
(86) International application number: PCT/JP2023/005318
(87) International publication number: WO 2024/089907

(57) **Abstract**

A substrate processing apparatus includes a loading device for loading a chip, which is attached to a tape covering an opening of a frame, from the tape onto a transfer plate; a first cleaning device for cleaning a front surface of the chip in a state where the transfer plate is holding the chip; a first activating device for activating the front surface of the chip in the state where the transfer plate is holding the chip; and a bonding device for detaching the chip from the transfer plate and bonding the detached chip to a substrate with the front surface of the chip facing the substrate.

## Description

### TECHNICAL FIELD

The various aspects and embodiments described herein pertain generally to a substrate processing apparatus and a substrate processing method.

### BACKGROUND

A chip mounting system described in Patent Document 1 includes a chip supply device, a bonding device, a surface processing device, a carry-in/out section, and a transfer section (paragraph [0225] of Patent Document 1). The chip supply device supplies a plurality of chips individually. The bonding device mounts the chips supplied from the chip supply device on a substrate.

### PRIOR ART DOCUMENT

Patent Document 1: Japanese Patent No. 6337400

### DISCLOSURE OF THE INVENTION

### PROBLEMS TO BE SOLVED BY THE INVENTION

Exemplary embodiments provide a technique capable of suppressing contamination that might be caused by a foreign matter attached to a tape.

### MEANS FOR SOLVING THE PROBLEMS

In an exemplary embodiment, a substrate processing apparatus includes a loading device configured to load a chip, which is attached to a tape covering an opening of a frame, from the tape onto a transfer plate; a first cleaning device configured to clean a front surface of the chip in a state where the transfer plate is holding the chip; a first activating device configured to activate the front surface of the chip in the state where the transfer plate is holding the chip; and a bonding device configured to detach the chip from the transfer plate and bond the detached chip to a substrate with the front surface of the chip facing the substrate.

### EFFECT OF THE INVENTION

According to the exemplary embodiments, it is possible to suppress contamination that might be caused by the foreign matter attached to the tape.

### BRIEF DESCRIPTION OF THE DRAWINGS

**FIG. 1** is a plan view illustrating a substrate processing apparatus according to an exemplary embodiment.
**FIG. 2** is a cross sectional view illustrating an example of a chip-attached substrate.
**FIG. 3** is a cross sectional view illustrating an example of a substrate.
**FIG. 4** is a cross sectional view illustrating an example of chips attached to a tape.
**FIG. 5** is a cross sectional view illustrating an example of a transfer plate.
**FIG. 6** is a cross sectional view illustrating an example of chips loaded on the transfer plate.
**FIG. 7** is a cross sectional view illustrating an example of a loading device.
**FIG. 8** is a cross sectional view illustrating an example of a bonding device.
**FIG. 9** is a flowchart showing a substrate processing method according to the exemplary embodiment.
**FIG. 10A** is a side view illustrating an example of a plurality of first attraction heads, and **FIG. 10B** is a bottom view of the plurality of first attraction heads shown in **FIG. 10A****.**
**FIG. 11** is a cross sectional view illustrating a modification example of the first attraction head.
**FIG. 12** is a cross sectional view illustrating a first modification example of the transfer plate.
**FIG. 13** is a cross sectional view illustrating a second modification example of the transfer plate.
**FIG. 14** is a cross sectional view illustrating a third modification example of the transfer plate.
**FIG. 15A** is a cross sectional view illustrating a fourth modification example of the transfer plate, **FIG. 15B** is a cross sectional view illustrating a state in which a chip is attracted, and **FIG. 15C** is a cross sectional view illustrating a state in which the chip is transferred.

### DETAILED DESCRIPTION

Hereinafter, exemplary embodiments of the present disclosure will be described with reference to the accompanying drawings, which form a part hereof. In the various drawings, same or corresponding parts will be assigned same or corresponding reference numerals, and redundant descriptions thereof will be omitted. In the present specification, the X-axis direction, the Y-axis direction, and the Z-axis direction are orthogonal to each other. The X-axis direction and the Y-axis directions are horizontal directions, whereas the Z-axis direction is a vertical direction.

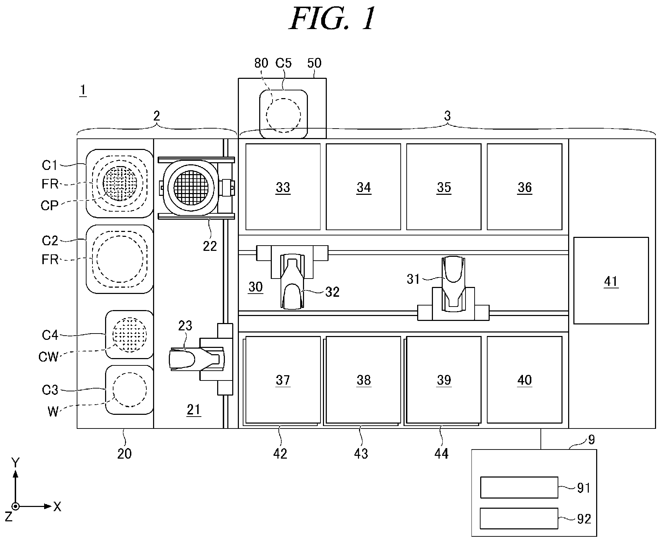

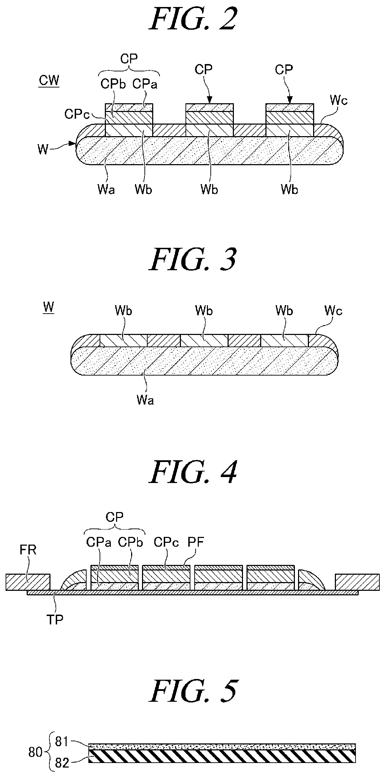

Referring to **FIG. 1** to **FIG. 8****,** a substrate processing apparatus 1 according to an exemplary embodiment will be described. As shown in **FIG. 2****,** the substrate processing apparatus 1 manufactures a substrate CW on which chips are attached by bonding the chips CP to a substrate W ("chip-attached substrate"). The chip-attached substrate CW includes the substrate W and the multiple chips CP bonded to the substrate W.

The substrate W has a base substrate Wa, and a plurality of devices Wb formed on the base substrate Wa. The base substrate Wa is, by way of non-limiting example, a silicon wafer, a compound semiconductor wafer, or a glass substrate. The devices Wb include semiconductor elements, circuits, terminals, and the like. The devices Wb are formed on a main surface Wc of the substrate W.

The chip CP has a base substrate CPa, and a device CPb formed on the base substrate CPa. The base substrate CPa is, by way of non-limiting example, a silicon wafer, a compound semiconductor wafer, or a glass substrate. The device CPb includes a semiconductor element, a circuit, a terminal, and the like. The device CPb is formed on a front surface CPc of the chip CP.

The substrate processing apparatus 1 bonds the chip CP to the substrate W with the front surface CPc of the chip CP facing the main surface Wc of the substrate W. The device CPb of the chip CP and the device Wb of the substrate W are electrically connected. As shown in **FIG. 1****,** the substrate processing apparatus 1 is equipped with a carry-in/out station 2, a processing station 3, and a controller 9. The carry-in/out station 2 and the processing station 3 are arranged in this order from the negative X-axis side toward the positive X-axis side.

The carry-in/out station 2 includes a first placement table 20. Cassettes C1 to C4 are mounted on the first placement table 20. The cassette C1 accommodates the multiple chips CP together with a frame FR. The cassette C2 holds the used frame FR from which at least some of the chips CP have been removed. The cassette C3 holds the substrate W before being bonded to the chips CP. The cassette C4 holds the chip-attached substrate CW.

As shown in **FIG. 4****,** the multiple chips CP are attached to a tape TP that covers an opening of the frame FR, and the multiple chips CP are arranged in the opening of the frame FR. The multiple chips CP are obtained by, for example, dicing the substrate in a state where the substrate is attached to the tape TP. The front surface CPc of each chip CP is protected by a protective film PF before the substrate is diced. The protective film PF is disposed on the opposite side of the tape TP with the chips CP therebetween.

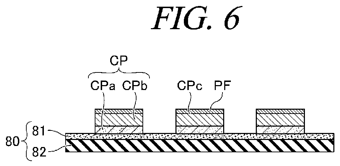

The chips CP are loaded from the tape TP onto a transfer plate 80, removed from the transfer plate 80, turned upside down, and bonded to the substrate W. The protective film PF is eliminated before the chips CP are bonded to the substrate W. Although not particularly limited, the transfer plate 80 has an adhesive tape 81 to which the chips CP are attached, and a flexible sheet 82 to which the adhesive tape 81 is attached, as shown in **FIG. 5** and **FIG. 6****,** for example.

The adhesive tape 81 is not temperature-sensitive in the present exemplary embodiment, but it may be temperature-sensitive and its adhesive strength may vary depending on temperature. By controlling the temperature of the transfer plate 80, the chips CP can be easily separated. The flexible sheet 82 is made of such a material as rubber or resin. The rubber may be, by way of example, silicone rubber. The resin may be, for example, polyimide, urethane acrylate, or water-based urethane. As will be described in detail later, by locally transforming the flexible sheet 82, it is possible to reduce, for each chip CP, the bonding strength between the chip CP and the transfer plate 80.

As illustrated in FIG. 1, the carry-in/out station 2 includes a transfer area 21, a third transfer arm 22, and a fourth transfer arm 23. The transfer area 21 is adjacent to the first placement table 20. The third transfer arm 22 holds and transfers the frame FR in the transfer area 21. The fourth transfer arm 23 holds and transfers the substrate W in the transfer area 21. Each of the third transfer arm 22 and the fourth transfer arm 23 is configured to be movable in horizontal directions (both in the X-axis direction and the Y-axis direction) and a vertical direction, and pivotable around a vertical axis.

The carry-in/out station 2 has a non-illustrated driver configured to move or rotate the third transfer arm 22 and the fourth transfer arm 23. The third transfer arm 22 and the fourth transfer arm 23 may be mounted on different Y-axis sliders as shown in **FIG. 1** to be moved in the Y-axis direction independently, or may be mounted on one and the same Y-axis slider to be moved in the Y-axis direction together. When the third transfer arm 22 and the fourth transfer arm 23 are mounted on the same Y-axis slider, they are stacked in the Z-axis direction. When the third transfer arm 22 and the fourth transfer arm 23 are mounted on the different Y-axis sliders, the Y-axis sliders are arranged while being shifted from each other in the Z-axis direction.

The third transfer arm 22 takes out the multiple chips CP together with the frame FR from the cassette C1, and transfers them to a loading device 33. The third transfer arm 22 also takes out the used frame FR from the loading device 33, and stores it in the cassette C2. The third transfer arm 22 serving to transfer the multiple chips CP together with the frame FR and the third transfer arm 22 serving to transfer the used frame FR may be provided separately.

The fourth transfer arm 23 takes out the substrate W before being bonded to the chips CP from the cassette C3, and transfers it to a substrate placing device 37. Also, the fourth transfer arm 23 takes out the chip-attached substrate CW from the substrate placing device 37, and stores it in the cassette C4. The fourth transfer arm 23 serving to transfer the substrate W before being bonded to the chips CP and the fourth transfer arm 23 serving to transfer the chip-attached substrate CW may be provided separately.

The processing station 3 includes a transfer area 30, a first transfer arm 31, and a second transfer arm 32. The transfer area 30 extends in the X-axis direction. The first transfer arm 31 holds and transfers the transfer plate 80 in the transfer area 30. The second transfer arm 32 holds and transfers the substrate W in the transfer area 30. Each of the first transfer arm 31 and the second transfer arm 32 is configured to be movable in horizontal directions (both the X-axis direction and the Y-axis direction) and a vertical direction, and pivotable around a vertical axis.

The processing station 3 has a non-illustrated driver configured to move or rotate the first transfer arm 31 and the second transfer arm 32. The first transfer arm 31 and the second transfer arm 32 may be mounted on different X-axis sliders as shown in **FIG. 1** to be moved in the X-axis direction independently, or may be mounted on one and the same X-axis slider to be moved in the X-axis direction together. When the first transfer arm 31 and the second transfer arm 32 are mounted on the same X-axis slider, they are stacked in the Z-axis direction. When the first transfer arm 31 and the second transfer arm 32 are mounted on the different X-axis sliders, the X-axis sliders are arranged while being shifted from each other in the Z-axis direction.

The first transfer arm 31 takes out the multiple chips CP together with the transfer plate 80 from the loading device 33, and transfers them to a bonding device 41 via a first cleaning device 34, a first plasma processing device 35, and a first hydrophilizing device 36. Also, the first transfer arm 31 takes out the transfer plate 80 from the bonding device 41, and transfers it to the loading device 33. Thereafter, the transfer plate 80 is returned to the cassette C5. Alternatively, the transfer plate 80 may be reused without being returned to the cassette C5, that is, it may be transferred to the first cleaning device 34 or the like while holding the chips CP thereon again.

The second transfer arm 32 takes out the substrate W before being bonded to the chips CP from the substrate placing device 37, and transfers it to the bonding device 41 via a second cleaning device 38, a second plasma processing device 39, and a second hydrophilizing device 40. Also, the second transfer arm 32 takes out the chip-attached substrate CW from the bonding device 41, and places it in the substrate placing device 37 via an inspecting device 42 or the like. The second transfer arm 32 serving to transfer the substrate W before being bonded to the chips CP and the second transfer arm 32 serving to transfer the chip-attached substrate CW may be provided separately.

It is desirable that the transfer plate 80 has the same diameter as the substrate W. In this case, the first transfer arm 31 and the second transfer arm 32 can be of the same model number (that is, the same size and the same shape), so costs can be reduced. Likewise, the first cleaning device 34 and the second cleaning device 38, the first plasma processing device 35 and the second plasma processing device 39, and the first hydrophilizing device 36 and the second hydrophilizing device 40 can also be of the same model numbers, respectively, so that the costs can be reduced. Furthermore, enlargement of the apparatus can also be suppressed.

The processing station 3 includes the loading device 33, the first cleaning device 34, the first plasma processing device 35, the first hydrophilizing device 36, the substrate placing device 37, the second cleaning device 38, the second plasma processing device 39, the second hydrophilizing device 40, the bonding device 41, the inspecting device 42, a separating device 43, and an annealing device 44. These individual devices 33 to 44 are adjacent to the transfer area 30, and are respectively arranged on the positive Y-axis side, the negative Y-axis side, or the positive X-axis side of the transfer area 30.

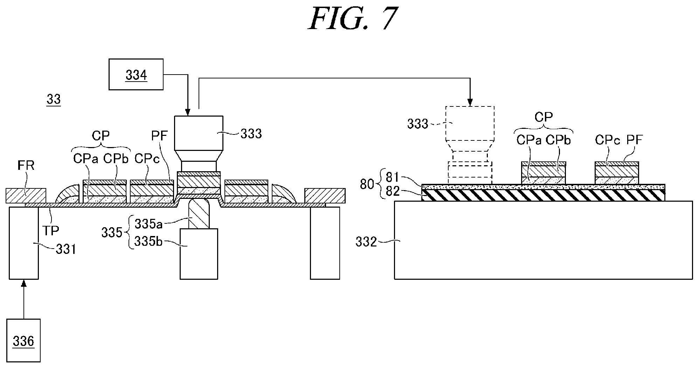

As shown in FIG. 7, the loading device 33 loads the chips CP, which are attached to the tape TP covering the opening of the frame FR, from the tape TP onto the transfer plate 80. The chips CP can be separated from a foreign matter attached to the tape TP, so contamination of the chip-attached substrate CW with the foreign matter can be suppressed. The foreign matter is, for example, particles generated when the substrate is diced into the multiple chips CP. In addition, when the transfer plate 80 has the same diameter as the substrate W, loading the chips CP onto the transfer plate 80 enables the substrate W and the chip CP to be processed by devices of the same model number.

Further, the loading device 33 may load multiple chips CP having different functions (different electric circuits) on the same transfer plate 80. The tape TP and the frame FR may be prepared for each of the different functions of the chips CP. That is, the multiple chips CP having the different functions may be attached to the different frames FR with the different tapes TP therebetween. In this case, the loading device 33 loads the multiple chips CP having the different functions from the tapes TP prepared for the different functions of the chips CP onto the same transfer plate 80. However, the multiple chips CP having the different functions may be attached to the same frame FR with the same tape TP therebetween. In this case, the loading device 33 loads the multiple chips CP having the different functions from the same tape TP onto the same transfer plate 80.

The loading device 33 has a third holding table 331, a fourth holding table 332, a third attraction head 333, and a third driver 334. The third holding table 331 holds the frame FR. The fourth holding table 332 holds the transfer plate 80. The third attraction head 333 attracts the chip CP. The front surface CPc of the chip CP is covered with the protective film PF, and the third attraction head 333 attracts the chip CP through the protective film PF. The third attraction head 333 comes into contact with the protective film PF. The third driver 334 moves the third attraction head 333 horizontally and vertically, thus allowing the chip CP attracted by the third attraction head 333 to be loaded onto the transfer plate 80 from the tape TP.

The loading device 33 has a second pressing device 335. The second pressing device 335 locally presses the chip CP through the tape TP and locally transforms the tape TP. The chips CP can be pushed up individually, so when the chips CP are picked up, the chips CP can be suppressed from being rubbed against each other.

The second pressing device 335 has, for example, a pressing pin 335a configured to locally press the tape TP, and a driver 335b configured to drive the pressing pin 335a. The driver 335b includes, for example, an air cylinder. The driver 335b may include a servo motor that controls the position of the pressing pin 335a.

Although not shown, a multiple number of pressing pins 335a may press one chip CP. In this case, the controller 9 may perform a control of switching combinations of the pressing pins 335a to be used (including the number thereof) according to the size or shape of the chip CP.

The loading device 33 has a changing device 336 configured to move the third holding table 331 and the second pressing device 335 relative to each other to change the local transformation position of the tape TP. The second changing device 336 moves, for example, the third holding table 331 in the present exemplary embodiment, but it may be configured to move the second pressing device 335 instead or to move both of them.

As illustrated in **FIG. 1****,** the second placement table 50 is adjacent to the loading device 33, and the cassette C5 is placed on the second placement table 50. The cassette C5 accommodates therein the transfer plate 80. The loading device 33 has a non-illustrated internal transfer arm. The internal transfer arm takes out the transfer plate 80 from the cassette C5, and hands it over to the fourth holding table 332.

The cassette C5 may be placed on the first placement table 20 of the carry-in/out station 2. In this case, the fourth transfer arm 23 takes out the transfer plate 80 from the cassette C5, and hands it over to the fourth holding table 332.

The cassette C1 may be placed on the second placement table 50. In this case, the internal transfer arm of the loading device 33 takes out the multiple chips CP together with the frame FR from the cassette C1, and passes them onto the third holding table 331.

The first cleaning device 34 cleans the front surface CPc of the chip CP with the chip CP held by the transfer plate 80. The front surface CPc of the chip CP is oriented opposite to the transfer plate 80. When the front surface CPc of the chip CP is covered with the protective film PF, the first cleaning device 34 removes the protective film PF. The front surface CPc of the chip CP can be purified. Thereafter, activation and bonding may be performed, so that intrusion of foreign matters such as bubbles or particles during the bonding can be suppressed. Since the chip CP has been completely transferred from the tape TP onto the transfer plate 80, the influence of particles generated during the dicing is small, and the chip CP can be purified more effectively. Therefore, defects during the activation and the bonding can be suppressed.

The first plasma processing device 35 plasma-processes the front surface CPc of the chip CP. For example, in the first plasma processing device 35, an oxygen gas, which is a processing gas, is excited into plasma under a reduced pressure to be ionized. The oxygen ions are radiated to the front surface CPc of the chip CP, thereby modifying the front surface CPc of the chip CP. The processing gas is not limited to the oxygen gas, and may be, by way of non-limiting example, a nitrogen gas. The first plasma processing device 35 is an example of a first activating device. The first activating device activates the front surface CPc of the chip CP.

The first hydrophilizing device 36 hydrophilizes the front surface CPc of the chip CP. By way of example, the first hydrophilizing device 36 supplies pure water (e.g., deionized water) onto the chip CP while rotating the transfer plate 80 held by a spin chuck. The pure water applies OH groups to the previously modified front surface CPc of the chip CP. The chip CP and the substrate W can be bonded through hydrogen bonding between the OH groups. The first hydrophilizing device 36 is an example of the first activating device.

The substrate W before being bonded to the chip CP is placed in the substrate placing device 37. The chip-attached substrate CW may also be placed in the substrate placing device 37. The substrate placing device 37 in which the substrate W before being bonded to the chip CP is placed and the substrate placing device 37 in which the chip-attached substrate CW is placed may be provided separately, and each may be provided in plural numbers.

The second cleaning device 38 cleans the main surface Wc of the substrate W. The main surface Wc of the substrate W can be purified. Thereafter, activation and bonding are performed, so that intrusion of foreign matters such as bubbles or particles can be suppressed during the bonding.

The second plasma processing device 39 plasma-processes the main surface Wc of the substrate W. For example, in the second plasma processing device 39, an oxygen gas, which is a processing gas, is excited into plasma under a reduced pressure to be ionized. The oxygen ions are radiated to the main surface Wc of the substrate W, thereby modifying the main surface Wc of the substrate W. The processing gas is not limited to the oxygen gas, and may be, by way of example, a nitrogen gas. The second plasma processing device 39 is an example of a second activating device.

The second hydrophilizing device 40 hydrophilizes the main surface Wc of the substrate W. For example, the second hydrophilizing device 40 supplies pure water (e.g., deionized water) onto the substrate W while rotating the substrate W held by a spin chuck. The pure water applies OH groups to the previously modified main surface Wc of the substrate W. The chip CP and the substrate W can be bonded through hydrogen bonding between the OH groups. The second hydrophilizing device 40 is an example of the second activating device.

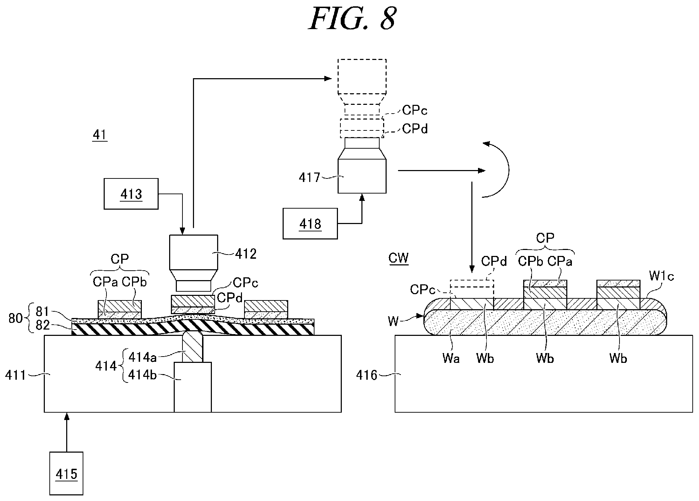

The bonding device 41 detaches the chip CP from the transfer plate 80, as illustrated in **FIG. 8****,** and bonds the chip CP to the substrate W with the front surface CPc of the detached chip CP facing the main surface Wc of the substrate W. As a result, the chip-attached substrate CW is obtained. The device CPb of the chip CP and the device Wb of the substrate W are electrically connected.

Further, the bonding device 41 may bond multiple chips CP having different functions (different electric circuits) to one and the same substrate W. The multiple chips CP having the different functions are electrically connected to the one device Wb. The substrate W may have multiple devices Wb, and the multiple chips CP having the different functions are electrically connected to each of the multiple devices Wb. The number of the chips CP electrically connected to one device Wb is not particularly limited.

The bonding device 41 has a first holding table 411, a first attraction head 412, and a first driver 413. The first holding table 411 holds the transfer plate 80. The first attraction head 412 attracts the front surface CPc of the chip CP in a non-contact manner. The first driver 413 moves the first attraction head 412 horizontally and vertically. The first driver 413 moves the first attraction head 412 relatively away from the transfer plate 80, thereby detaching the chip CP from the transfer plate 80.

The first attraction head 412 attracts the front surface CPc of the chip CP with a gap formed between the first attraction head 412 and the chip CP. Thus, contamination of the front surface CPc of the chip CP can be suppressed. The first attraction head 412 is, for example, of an ultrasonic type or a Bernoulli type. The ultrasonic type uses a squeeze effect caused by ultrasonic vibration, and the Bernoulli type uses a Bernoulli effect. The ultrasonic type can suppress horizontal misalignment, as compared to the Bernoulli type.

The bonding device 41 has a first pressing device 414. The first pressing device 414 locally presses the chip CP with the transfer plate 80 therebetween and locally transforms the transfer plate 80. The first pressing device 414 transforms the transfer plate 80 such that the transfer plate 80 locally projects upwards, thus forming a wedge-shaped gap at a periphery of a bottom surface of the chip CP to reduce the bonding strength between the chip CP and the transfer plate 80. This makes it possible to easily detach the chip CP from the transfer plate 80.

The first attraction head 412 attracts, in a non-contact manner, the chip CP pressed by the first pressing device 414. Since the gap is formed between the first attraction head 412 and the chip CP, the attraction force is weak. According to the present exemplary embodiment, however, the transfer plate 80 is locally transformed to be projected upwards, so that the wedge-shaped gap is formed at the periphery of the bottom surface of the chip CP, and the bonding strength between the chip CP and the transfer plate 80 is reduced. Therefore, even if the attraction force is weak, the chip CP can be detached from the transfer plate 80.

The first pressing device 414 has a pressing pin 414a configured to locally press the transfer plate 80, and a driver 414b configured to drive the pressing pin 414a. The driver 414b includes, for example, a servo motor that controls the position of the pressing pin 414a. By controlling the position of the pressing pin 414a, a contact between the chip CP and the first attraction head 412 can be suppressed.

Although not shown, multiple pressing pins 414a may press one chip CP. In this case, the controller 9 may perform a control of switching combinations of the pressing pins 414a to be used (including the number thereof) according to the size or shape of the chip CP.

The bonding device 41 has a first changing device 415 configured to move the first holding table 411 and the first pressing device 414 relative to each other to change the local transformation position of the transfer plate 80. The first changing device 415 moves, for example, the first holding table 411 in the present exemplary embodiment, but it may be configured to move the first pressing device 414 instead or to move both of them.

The bonding device 41 has a second holding table 416, a second attraction head 417, and a second driver 418. The second holding table 416 holds the substrate W. The second attraction head 417 receives the chip CP from the first attraction head 412, and attracts the rear surface CPd of the chip CP which is opposite the front surface CPc. Since contamination of the rear surface CPd is not of concern, the second attraction head 417 comes into contact with the chip CP.

The second driver 418 moves the second attraction head 417 horizontally and vertically, allowing the chip CP and the substrate W to be bonded so that the front surface CPc of the chip CP attracted by the second attraction head 417 faces the main surface Wc of the substrate W. The second driver 418 turns the second attraction head 417 upside down in order to turn the chip CP upside down.

Instead of the second driver 418 turning the second attraction head 417 upside down in order to turn the chip CP upside down, the first driver 413 may turn the first attraction head 412 upside down. In the latter case, it is desirable that the first attraction head 412 is of an ultrasonic type. Unlike a Bernoulli type, the ultrasonic type can turn the chip CP upside down while attracting it in a non-contact manner.

The inspecting device 42 (see **FIG. 1**) inspects whether the bonding state between the substrate W and the chip CP is acceptable or defective. The inspection is performed for each chip CP. The inspection items include at least one of presence or absence of a foreign matter such as a bubble and presence or absence of any misalignment. By way example, if bubbles are present at an interface between the substrate W and the chip CP, the bubbles will burst when the chip-attached substrate CW is processed in a vacuum. The bursting of the bubbles may cause a defect on a chip CP whose bonding state is proper, or may contaminate a vacuum chamber. Further, if bubbles or particles are present at the interface between the substrate W and the chip CP, the height of the chip CP will increase, causing chipping during grinding or polishing, and due to the impact, even a chip CP in a proper bonding state may be negatively affected.

The separating device 43 separates, from the substrate W, the chip CP which has been found by the inspecting device 42 to be in an improper bonding state. By separating the improperly bonded chip CP from the substrate W, problems that might be caused when bubbles or particles are present at the interface between the substrate W and the chip CP can be suppressed, so that the quality of the chip-attached substrate CW can be improved. The chip CP separated from the substrate W may be reused or discarded.

The annealing device 44 heats the chip-attached substrate CW. Before the heating processing, the chip CP and the substrate W have been bonded through the hydrogen bonding between the OH groups. Through the heating processing, a dehydration condensation reaction occurs, resulting in formation of covalent bonds, which enhances the bonding strength between the chip CP and the substrate W. Further, the separation of the chips CP by the separating device 43 is performed before the heating processing of the chip-attached substrate CW by the annealing device 44.

The controller 9 is, for example, a computer, and includes an operation unit 91 such as a CPU (Central Processing Unit), and a storage 92 such as a memory. The storage 92 stores a program that controls various processes performed in the substrate processing apparatus 1. The controller 9 controls the operation of the substrate processing apparatus 1 by causing the operation unit 91 to execute the program stored in the storage 92. A unit controller that controls the operation of each of units constituting the substrate processing apparatus 1 may be provided, and a system controller that controls the multiple unit controllers may be provided. The controller 9 may be composed of the unit controllers and the system controller.

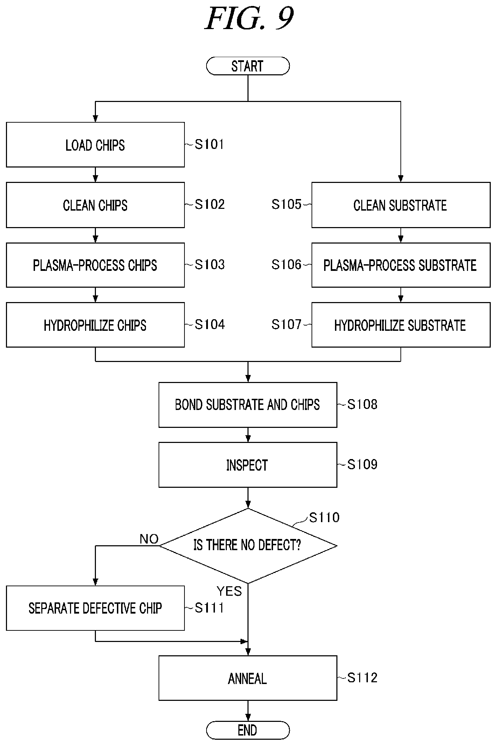

Now, a substrate processing method according to an exemplary embodiment will be described with reference to FIG. 9. The processing of FIG. 9 is performed under the control of the controller 9.

First, the third transfer arm 22 of the carry-in/out station 2 takes out the multiple chips CP together with the frame FR from the cassette C1, and transfers them to the loading device 33. Next, the loading device 33 loads the chips CP from the tape TP onto the transfer plate 80 (process S101). Thereafter, the first transfer arm 31 of the processing station 3 takes out the multiple chips CP together with the transfer plate 80 from the loading device 33, and transfers them to the first cleaning device 34. Subsequently, the first cleaning device 34 cleans the front surface CPc of each of the multiple chips CP (process S102). Then, the first transfer arm 31 takes out the multiple chips CP together with the transfer plate 80 from the first cleaning device 34, and transfers them to the first plasma processing device 35. Next, the first plasma processing device 35 plasma-processes the front surface CPc of each of the multiple chips CP (process S103). Afterwards, the first transfer arm 31 takes out the multiple chips CP together with the transfer plate 80 from the first plasma processing device 35, and transfers them to the first hydrophilizing device 36. Next, the first hydrophilizing device 36 hydrophilizes the front surface CPc of each of the multiple chips CP (process S104). Thereafter, the first transfer arm 31 takes out the multiple chips CP together with the transfer plate 80 from the first hydrophilizing device 36, and transfers them to the bonding device 41.

In parallel with the above-described processing, the following processing is performed. First, the fourth transfer arm 23 of the carry-in/out station 2 takes out the substrate W from the cassette C3, and transfers it to the substrate placing device 37. Then, the second transfer arm 32 of the processing station 3 takes out the substrate W from the substrate placing device 37, and transfers it to the second cleaning device 38. Next, the second cleaning device 38 cleans the main surface Wc of the substrate W (process S105). Then, the second transfer arm 32 takes out the substrate W from the second cleaning device 38, and transfers it to the second plasma processing device 39. Subsequently, the second plasma processing device 39 plasma-processes the main surface Wc of the substrate W (process S106). Thereafter, the second transfer arm 32 takes out the substrate W from the second plasma processing device 39, and transfers it to the second hydrophilizing device 40. Next, the second hydrophilizing device 40 hydrophilizes the main surface Wc of the substrate W (process S107). Thereafter, the second transfer arm 32 takes out the substrate W from the second hydrophilizing device 40, and transfers it to the bonding device 41.

Then, the bonding device 41 detaches the chip CP from the transfer plate 80, and bonds the chip CP to the substrate W with the front surface CPc of the detached chip CP facing the main surface Wc of the substrate W (process S108). As a result, the chip-attached substrate CW is obtained. Afterwards, the second transfer arm 32 takes out the chip-attached substrate CW from the bonding device 41, and transfers it to the inspecting device 42.

Next, the inspecting device 42 inspects whether the bonding state between the substrate W and the chip CP is acceptable or defective (process S109). The inspecting device 42 transmits an inspection result to the controller 9. The controller 9 checks whether there is a defect (process S110). The controller 9 controls the transfer destination of the chip-attached substrate CW to the annealing device 44 or the separating device 43 according to the inspection result from the inspecting device 42.

If there is a defect in the bonding state of the chip CP (process S110, NO), the transfer destination of the chip-attached substrate CW is set to be the separating device 43. The second transfer arm 32 takes out the chip-attached substrate CW from the inspecting device 42, and transfers it to the separating device 43. Next, the separating device 43 separates the chip CP in the defective bonding state from the substrate W (process S111). Thereafter, the second transfer arm 32 takes out the chip-attached substrate CW from the separating device 43, and transfers it to the annealing device 44. Then, the processing from the process S112 onwards is performed.

The first transfer arm 31 may take out the chip-attached substrate CW from the separating device 43 and transfer it to the bonding device 41. The bonding device 41 re-bonds a new chip CP to the position from which the defective chip CP has been removed. Then, the processing from the process S109 onwards may be performed again.

On the other hand, if there is no defect in the bonding state of all the chips CP (process S110, YES), the transfer destination of the chip-attached substrate CW is set to be the annealing device 44. The second transfer arm 32 takes out the chip-attached substrate CW from the separating device 42, and transfers it to the annealing device 44. Then, the annealing device 44 heats the chip-attached substrate CW (process S112). Due to this heating processing, the bonding strength between the chip CP and the substrate W is enhanced.

Thereafter, the second transfer arm 32 takes out the chip-attached substrate CW from the annealing device 44, and places it in the substrate placing device 37. Finally, the fourth transfer arm 23 of the carry-in/out station 2 takes out the chip-attached substrate CW from the substrate placing device 37, and stores it in the cassette C4. The chip-attached substrate CW is carried out from the substrate processing apparatus 1 while being still stored in the cassette C4. ( 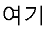

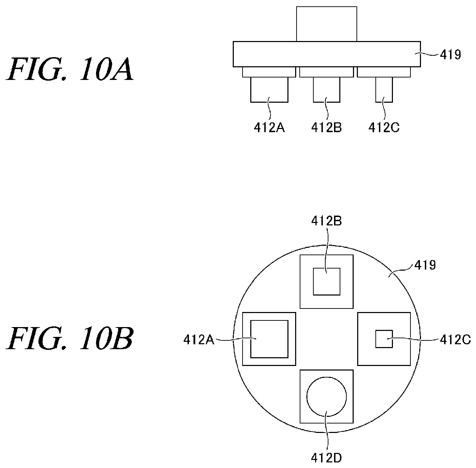

Now, referring to **FIG. 10A** and **FIG. 10B****,** an example of a plurality of first attraction heads 412A to 412D will be described. As illustrated in **FIG. 10A** and **FIG. 10B****,** the plurality of first attraction heads 412A to 412D may be prepared. The plurality of first attraction heads 412A to 412D have different sizes or different shapes. The controller 9 controls a switchover between the first attraction heads 412A to 412D according to the size or the shape of the chip CP concerned. As a result, replacement (attachment/detachment) of the first attraction heads 412A to 412D can be omitted.

The multiple first attraction heads 412A to 412D are mounted to a single holder 419. The first driver 413 moves the holder 419 to move the plurality of first attraction heads 412A to 412D together. The first driver 413 may rotate the holder 419. The controller 9 controls the movement or the rotation of the holder 419 to perform the control of switching between the first attraction heads 412A to 412D. Thus, the work of replacing (detaching/attaching) the first attraction heads 412A to 412D onto the holder 419 can be omitted.

When the plurality of first attraction heads 412A to 412D are of an ultrasonic type, the holder 419 is provided with an ultrasonic vibrator. The single ultrasonic vibrator vibrates the plurality of first attraction heads 412A to 412D collectively. Here, the ultrasonic vibrator may be plural in number, and the plurality of first attraction heads 412A to 412D may be vibrated individually.

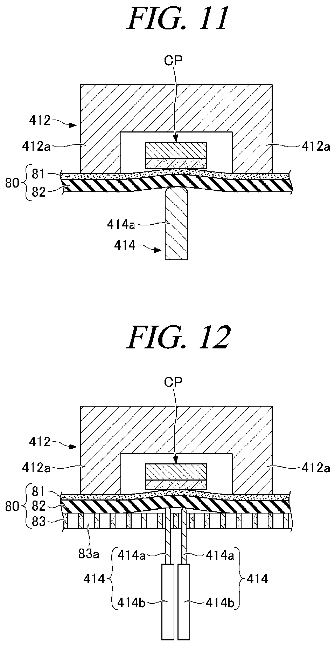

Now, referring to **FIG. 11****,** a modification example of the first attraction head 412 will be described. As shown in **FIG. 11****,** the first attraction head 412 has a restraining portion 412a for restraining transformation of the transfer plate 80 around the chip CP. A pair of restraining portions 412a may be provided with the chip CP therebetween, or the single restraining portion 412a may be provided in a ring shape to surround the chip CP. Since a portion of the flexible sheet 82 can be selectively transformed, unintended separation of the chip CP can be suppressed.

Next, referring to **FIG. 12****,** the transfer plate 80 according to a first modification example will be explained. As depicted in **FIG. 12****,** the transfer plate 80 may have a mesh plate 83 on which the flexible sheet 82 is detachably attached. The mesh plate 83 has a plurality of through holes 83a. In a plan view (when viewed from the top), each through hole 83a is smaller than the chip CP.

The first pressing device 414 presses one chip CP through the flexible sheet 82 with a plurality of pressing pins 414a inserted through the plurality of through holes 83a. The driver 414b moves the plurality of pressing pins 414a independently. The controller 9 performs a control of switching the combinations of the pressing pins 414a to be moved (including the number thereof) according to the size or the shape of the chip CP concerned.

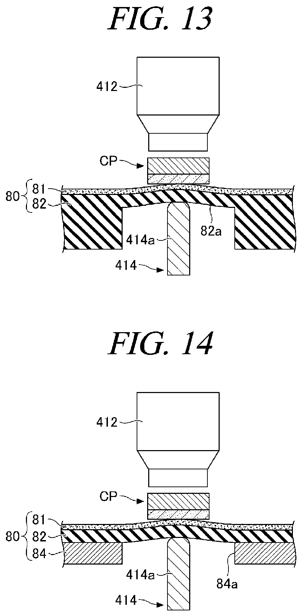

Now, referring to **FIG. 13****,** the transfer plate 80 according to a second modification example will be explained. As shown in **FIG. 13****,** the flexible sheet 82 of the transfer plate 80 has a recess 82a on its surface opposite to the chip CP. The recess 82a is provided for each chip CP. In a plan view (when viewed from the top), the recess 82a is larger than the chip CP.

The loading device 33 loads the chip CP on a portion of the transfer plate 80 that has been thinned due to the presence of the recess 82a. The first pressing device 414 presses the chip CP through the flexible sheet 82 with the pressing pin 414a inserted into the recess 82a. By using a difference in stiffness due to the difference in thickness, a portion of the flexible sheet 82 can be selectively transformed, so that the unintended separation of the chip CP can be suppressed.

Next, referring to **FIG. 14****,** the transfer plate 80 according to a third modification example will be described. As shown in **FIG. 14****,** the transfer plate 80 has a restraining plate 84 that restrains the transformation of the flexible sheet 82. The restraining plate 84 is made of a metal. The metal may be, by way of non-limiting example, stainless steel. The restraining plate 84 has a through hole 84a. The through hole 84a is provided for each chip CP. In a plan view (when viewed from the top), the through hole 84a is larger than the chip CP.

The loading device 33 loads the chip CP on a portion of the transfer plate 80 where the through hole 84a is provided. The first pressing device 414 presses the chip CP through the flexible sheet 82 with the pressing pin 414a inserted into the through hole 83a of the restraining plate 84. Since a portion of the flexible sheet 82 can be selectively transformed, unintended separation of the chip CP can be suppressed.

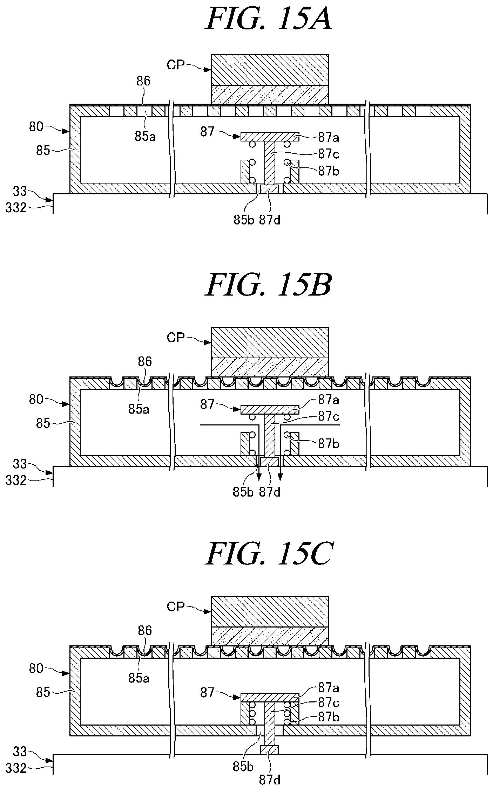

Now, referring to **FIG. 15A to FIG. 15C****,** the transfer plate 80 according to a fourth modification example will be discussed. As illustrated in **FIG. 15A to FIG. 15C****,** the transfer plate 80 has a hollow plate 85, a plurality of through holes 85a provided in one surface of the hollow plate 85, an elastic film 86 covering the plurality of through holes 85a, a communication hole 85b through which an internal space of the hollow plate 85 communicate with an external space thereof, and an opening/closing valve 87 for opening or closing the communication hole 85b.

The elastic film 86 covers a top surface of the hollow plate 85, for example. The elastic film 86 is a rubber film or a resin film. When the internal space of the hollow plate 85 is decompressed as compared to the external space thereof, a portion of the elastic film 86 is gently curved due to the pressure difference and sucked into the through hole 85a. The communication hole 85b is provided on a surface of the hollow plate 85 that is exposed from the elastic film 86, for example, on a bottom surface of the hollow plate 85.

The opening/closing valve 87 has a valve main body 87a configured to be movable between an opening position (see **FIG. 15A** and **FIG. 15B**) where it opens the communication hole 85b and a closing position (see **FIG. 15C**) where it closes the communication hole 85b; and a biasing member 87b configured to force the valve main body 87a from the opening position toward the closing position. The valve main body 87a and the biasing member 87b are provided in the internal space of the hollow plate 85. The biasing member 87b is, by way of example, a spring.

The opening/closing valve 87 has a valve stem 87c configured to press the valve main body 87a, and a flange 87d provided at one end (for example, a lower end) of the valve stem 87c. The valve main body 87a is provided at the other end (for example, an upper end) of the valve stem 87c. The valve main body 87a, the valve stem 87c, and the flange 87d are configured as one body. The valve stem 87c passes through the communication hole 85b. The flange 87d is moved between a position where it is received in the communication hole 85b (see **FIG. 15A** and **FIG. 15B**) and a position where it is protruded from the hollow plate 85 (see **FIG. 15C**).

When the transfer plate 80 is loaded on the fourth holding table 332 in the loading device 33, a top surface of the fourth holding table 332 presses the flange 87d upwards, so the flange 87d is received in the communication hole 85b, as shown in **FIG. 15A****.** As the flange 87d is moved upwards, the valve main body 87a is moved from the closing position to the opening position. At this time, there is no pressure difference between the internal space of the hollow plate 85 and the external space of the hollow plate 85, and the elastic film 86 is flat in its entire surface. In this state, the chip CP is placed on the elastic film 86.

Next, a non-illustrated suction source (for example, a vacuum pump) sucks in a gas from the internal space of the hollow plate 85 to the external space of the hollow plate 85 through the communication hole 85b. When the internal space of the hollow plate 85 is decompressed as compared to the external space of the hollow plate 85, a portion of the elastic film 86 is gently curved due to the pressure difference and sucked into the through hole 85a. As a result, as shown in **FIG. 15B****,** a vacuum space is formed between the bottom surface of the chip CP and the elastic film 86, so that the chip CP is attracted to the transfer plate 80.

Next, when the transfer plate 80 is removed from the fourth holding table 332, the biasing member 87b moves the valve main body 87a from the opening position to the closing position, as shown in **FIG. 15C****.** This allows the pressure of the internal space of the hollow plate 85 to be maintained lower than the external space of the hollow plate 85. Accordingly, the state in which the vacuum space is formed between the bottom surface of the chip CP and the elastic film 86 is maintained, so that the chip CP is kept attracted to the transfer plate 80.

The chip CP is transferred to the bonding device 41 through the first cleaning device 34, the first plasma processing device 35, and the first hydrophilizing device 36 while being attracted to the transfer plate 80. Then, in the bonding device 41, the first attraction head 412 attracts the chip CP in a non-contact manner. The attraction force of the first attraction head 412 is greater than the attraction force of the transfer plate 80. Therefore, the chip CP can be removed from the transfer plate 80.

So far, the substrate processing apparatus and the substrate processing method according to the exemplary embodiment of the present disclosure have been described. However, the present disclosure is not limited to the above-described exemplary embodiment. Various changes, modifications, substitutions, additions, deletions and combinations may be made within the scope of the claims, which are all incorporated within a technical scope of the present disclosure.

This application claims priority to Japanese Patent Application No. 2022-172036, filed on October 27, 2022, which application is hereby incorporated by reference in their entirety.

### EXPLANATION OF CODES

1: Substrate processing apparatus
33: Loading device
34: First cleaning device
34: First plasma processing device (first activating device)
36: First hydrophilizing device (First activating device)
41: Bonding device
80: Transfer plate
CP: Chip
FR: Frame
TP: Tape
W: Substrate

## Claims

1. A substrate processing apparatus, comprising:
a loading device configured to load a chip, which is attached to a tape covering an opening of a frame, from the tape onto a transfer plate;
a first cleaning device configured to clean a front surface of the chip in a state where the transfer plate is holding the chip;
a first activating device configured to activate the front surface of the chip in the state where the transfer plate is holding the chip; and
a bonding device configured to detach the chip from the transfer plate and bond the detached chip to a substrate with the front surface of the chip facing the substrate.

2. The substrate processing apparatus of Claim 1,
wherein the bonding device comprises a first attraction head configured to attract the front surface of the chip in a non-contact manner.

3. The substrate processing apparatus of Claim 2,
wherein the bonding device comprises a first pressing device configured to locally press the chip through the transfer plate and locally transform the transfer plate, and
the first attraction head attracts the front surface of the chip pressed by the pressing device.

4. The substrate processing apparatus of Claim 3,
wherein the transfer plate comprises an adhesive tape to which the chip is attached, and a flexible sheet to which the adhesive tape is attached.

5. The substrate processing apparatus of Claim 4,
wherein the flexible sheet has a recess on a surface thereof opposite to the chip, and
the loading device loads the chip on a portion of the transfer plate that is thinned due to presence of the recess.

6. The substrate processing apparatus of Claim 4,
wherein the transfer plate comprises a restraining plate configured to restrain transformation of the flexible sheet,
the restraining plate is provided with a through hole, and
the loading device loads the chip on a portion of the transfer plate where the through hole is provided.

7. The substrate processing apparatus of Claim 3,
wherein the first attraction head comprises a restraining portion configured to restrain transformation of the transfer plate around the chip.

8. The substrate processing apparatus of any one of Claims 2 to 7,
wherein the first attraction head includes multiple first attraction heads, and
the bonding device comprises the multiple first attraction heads, and a controller configured to control a switchover between the first attraction heads to be used according to a size or a shape of the chip.

9. The substrate processing apparatus of any one of Claims 1 to 7,
wherein the transfer plate has a same diameter as the substrate.

10. The substrate processing apparatus of Claim 1 or 2,
wherein the transfer plate comprises a hollow plate, multiple through holes provided in one surface of the hollow plate, an elastic film covering the multiple through holes, a communication hole through which an internal space of the hollow space communicates with an external space of the hollow space, and an opening/closing valve configured to open or close the through hole.

11. A substrate processing method, comprising:
loading a chip, which is attached to a tape covering an opening of a frame, from the tape onto a transfer plate;
cleaning a front surface of the chip in a state where the transfer plate is holding the chip;
activating the front surface of the chip in the state where the transfer plate is holding the chip; and
detaching the chip from the transfer plate and bonding the detached chip to a substrate with the front surface of the chip facing the substrate.

12. The substrate processing method of Claim 11,
wherein the detaching of the chip from the transfer plate comprises spacing the first attraction head, which is attracting the front surface of the chip in a non-contact manner, relatively away from the transfer plate.

13. The substrate processing method of Claim 12,
wherein the detaching of the chip from the transfer plate comprises locally pressing the chip through the transfer plate and locally transforming the transfer plate, and
the first attraction head attracts the front surface of the chip, which is locally pressed, in the non-contact manner.

14. The substrate processing method of Claim 13,
wherein the transfer plate comprises an adhesive tape to which the chip is attached, and a flexible sheet to which the adhesive tape is attached.

15. The substrate processing method of Claim 14,
wherein the flexible sheet has a recess on a surface thereof opposite to the chip, and
the loading of the chip from the tape onto the transfer plate comprises loading the chip on a portion of the transfer plate that is thinned due to presence of the recess.

16. The substrate processing method of Claim 14,
wherein the transfer plate comprises a restraining plate configured to restrain transformation of the flexible sheet,
the restraining plate is provided with a through hole, and
the loading of the chip from the tape onto the transfer plate comprises loading the chip on a portion of the transfer plate where the through hole is provided.

17. The substrate processing method of Claim 13,
wherein the first attraction head comprises a restraining portion configured to restrain transformation of the transfer plate around the chip.

18. The substrate processing method of any one of Claims 12 to 17,
wherein the first attraction head includes multiple first attraction heads, and
the substrate processing method comprises switching between the multiple first attraction heads to be used according to a size or a shape of the chip.

19. The substrate processing method of any one of Claims 11 to 17,
wherein the transfer plate has a same diameter as the substrate.

20. The substrate processing method of Claim 11 or 12,
wherein the transfer plate comprises a hollow plate, multiple through holes provided in one surface of the hollow plate, an elastic film covering the multiple through holes, a communication hole through which an internal space of the hollow space communicates with an external space of the hollow space, and an opening/closing valve configured to open or close the through hole.
